# EUROPEAN PATENT APPLICATION

(11) **EP 3 591 460 A1**
(43) Date of publication of application: **08.01.2020**
(21) Application number: 19183359.9
(22) Date of filing: 28.06.2019
(51) Int. Cl.: G02F 1/1333

(54) **DISPLAY APPARATUS HAVING A PROTECTIVE SIDE-MEMBER SURROUNDING THE DISPLAY PANEL AND MANUFACTURING METHOD OF THE SAME**

(30) Priority: 03.07.2018 KR 20180076794
(71) Applicant: Samsung Display Co., Ltd., Gyeonggi-Do 17113 (KR)
(72) Inventor: PARK, Kyu-Tae, Gyeonggi-Do (KR); LEE, Jungil, Seoul (KR); BAE, Junhee, Chungcheongnam-do (KR)
(74) Representative: Taor, Simon Edward William

(57) **Abstract**

A display apparatus (DA) includes a display panel (DP), a bottom protective member (BS) including a bottom portion (LP) and a sidewall portion (WP), and a side protective member (TS) surrounding the sidewall portion and the display panel. The side protective member includes a first rectangular panel (P1) having a first thickness (T1) and a second rectangular panel (P2) having a second thickness (T2) . A first portion of the first panel extends adjacent to the display panel but does not cover the display surface. The second panel (P2) is disposed between a second portion of the first panel and the sidewall portion and is coupled to the first panel, wherein T2 > T1.

This rectangular panel arrangement facilitates the manufacture of the side protective member and reduces its tolerance range, while ensuring sufficient impact-resistance, improved reliability and appearance.

## Description

### BACKGROUND

### 1. Field

The disclosure herein relates to a display apparatus and a method of manufacturing the display apparatus, and more particularly, to a display apparatus including a narrow bezel and a method of manufacturing the display apparatus.

### 2. Description of the Related Art

A display apparatus may include a protective member which protects a display panel and various kinds of components included to drive the display panel. The protective member may protect the display panel and may constitute an external shape of the display apparatus. As a bezel surrounding a display surface of the display panel becomes narrower, the visibility of an image provided on the display surface may be improved and the aesthetics of the display apparatus may be improved.

### SUMMARY

The disclosure may provide a display apparatus with a reduced bezel, and a method of manufacturing the display apparatus.

The disclosure may also provide a method of manufacturing a display apparatus for improving assembly of the display apparatus.

In an embodiment of the invention, a display apparatus includes a display panel including a display surface, on which an image is displayed in an upward direction, a bottom protective member including a bottom portion parallel to the display panel, and a sidewall portion bent from the bottom portion in the upward direction, and a side protective member surrounding the sidewall portion and the display panel. In such an embodiment, the side protective member includes a first panel having a first thickness and coupled to the display panel, where the first panel exposes the display surface, and a second panel disposed between the first panel and the sidewall portion, coupled to the first panel, and having a second thickness greater than the first thickness.

In an embodiment, the side protective member may include a plurality of side protective members covering side surfaces of the display panel, respectively.

In an embodiment, a top edge of the first panel may be disposed at a same level as the display surface or may be higher than the display surface.

In an embodiment, the side surface of the display panel may overlap the first panel and may be exposed by the second panel when viewed in a side view.

In an embodiment, the first panel may include a resin.

In an embodiment, the second panel may include a metal or an alloy.

In an embodiment, the display apparatus may further include a screw member which couples the side protective member and the bottom protective member to each other. In such an embodiment, the screw member may be disposed through a through-hole defined in the first panel and the second panel.

In an embodiment, a first through-hole and a second through-hole, which are spaced apart from each other in an intersection direction intersecting the upward direction, may be defined in the side protective member. In such an embodiment, the first panel may have a top edge adjacent to the display surface, and a distance from a center of the first through-hole to the top edge of the first panel in the upward direction may be substantially equal to a distance from a center of the second through-hole to the top edge of the first panel in the upward direction.

In an embodiment, a distance between the top edge of the first panel and a top edge of the second panel may be constant along the intersection direction.

In an embodiment, a distance between the top edge of the first panel and a top edge of the second panel may vary along the intersection direction.

In an embodiment, the display apparatus may further include an intermediate protective member disposed between the display panel and the bottom protective member and supporting the display panel. In such an embodiment, the intermediate protective member may include a flat portion disposed between the sidewall portion and the side protective member, and a protrusion protruding from the flat portion in a direction intersecting the upward direction. In such an embodiment, the screw member may be disposed through the flat portion.

In an embodiment, the intermediate protective member may further include an oblique portion extending obliquely from the protrusion toward the bottom portion. In such an embodiment, the sidewall portion may be disposed between the flat portion and the oblique portion and may be coupled to the flat portion, and the bottom portion may be coupled to the oblique portion.

In an embodiment, the display apparatus may further include a cover member covering the side protective member and the bottom protective member. In such an embodiment, the cover member may cover at least a portion of the first panel and at least a portion of the bottom portion.

In an embodiment, the display apparatus may further include a light source disposed on the bottom portion, and an optical member disposed between the light source and the display panel.

In an embodiment, the display panel may include an organic light emitting element.

In an embodiment, the display apparatus may further include a coupling member disposed between the display panel and the side protective member to couple the display panel and the side protective member to each other. In such an embodiment, the coupling member may include a resin or a tape.

In an embodiment of the invention, a method of manufacturing a display apparatus may include providing a display panel, forming a side protective member, and assembling the side protective member with the display panel to cover an edge of the display panel. In such an embodiment, the forming the side protective member may include providing an initial first panel having a first width on a stage, providing an initial second panel having a second width less than the first width on the stage in a way such that the initial second panel is stacked on the initial first panel, and cutting the initial first panel along a cutting line to form a first panel. In such an embodiment, the cutting line may be defined to be spaced apart from the initial second panel.

In an embodiment, a plurality of first through-holes may be formed in the initial first panel to be arranged and spaced apart from each other in an extending direction of the cutting line, and a plurality of second through-holes may be formed in the initial second panel to be arranged and spaced apart from each other in the extending direction of the cutting line. In such an embodiment, the initial second panel may be provided on the stage in a way such that the second through-holes are aligned with the first through-holes, respectively.

In an embodiment, distances from centers of the second through-holes to the cutting line may be substantially equal to each other.

In an embodiment, a thickness of the initial first panel may be less than a thickness of the initial second panel.

In an embodiment, the cutting the initial first panel may include using a plotter or a laser generator.

According to an aspect of the invention, there is provided a display apparatus as set out in claim 1. Preferred features of this aspect are set out in claims 2 to 12. According to an aspect of the invention, there is provided a method of manufacturing a display apparatus as set out in claim 13. Preferred features of this aspect are set out in claims 14 to 15.

### BRIEF DESCRIPTION OF THE DRAWINGS

These and/or other features of the invention will become apparent and more readily appreciated from the following description of the exemplary embodiments, taken in conjunction with the accompanying drawings, in which:
FIG. 1 is a combined perspective view illustrating a display apparatus according to an embodiment of the invention;
FIG. 2 is an exploded perspective view illustrating the display apparatus of FIG. 1;
FIG. 3A is a cross-sectional view taken along line I-I' of FIG. 1;
FIG. 3B is an equivalent circuit diagram of a portion of a display panel illustrated in FIG. 2;
FIG. 4 is a cross-sectional view illustrating a display apparatus according to an alternative embodiment of the invention;
FIGS. 5A to 5C are side views illustrating side protective members according to some embodiments of the invention;
FIGS. 6A to 6C are side views illustrating side protective members according to some embodiments of the invention;
FIG. 7A is an exploded perspective view illustrating a display apparatus according to an alternative embodiment of the invention;
FIG. 7B is a combined cross-sectional view illustrating the display apparatus of FIG. 7A;
FIG. 7C is an equivalent circuit diagram schematically illustrating a component of the display apparatus of FIG. 7A;
FIGS. 8A and 8B are perspective views illustrating an electronic apparatus according to an embodiment of the invention;
FIGS. 9A to 9F are views illustrating a method of manufacturing some components of a display apparatus, according to an embodiment of the invention; and
FIG. 10 is a graph showing straightness of a plurality of side protective members.

### DETAILED DESCRIPTION

The invention now will be described more fully hereinafter with reference to the accompanying drawings, in which various embodiments are shown. The invention may, however, be embodied in many different forms, and should not be construed as limited to the embodiments set forth herein. Rather, these embodiments are provided so that this disclosure will be thorough and complete, and will fully convey the scopes of the invention to those skilled in the art. Like reference numerals refer to like elements throughout.

It will be understood that when an element such as a layer, region or substrate is referred to as being "on" another element, it can be directly on the other element or intervening elements may be present. In contrast, the term "directly" means that there are no intervening elements.

The terminology used herein is for the purpose of describing particular embodiments only and is not intended to be limiting. As used herein, the singular forms "a," "an," and "the" are intended to include the plural forms, including "at least one," unless the content clearly indicates otherwise. "Or" means "and/or." "At least A and B" means "A and/or B." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system).

Exemplary embodiments are described herein with reference to cross-sectional illustrations and/or plane illustrations that are idealized exemplary illustrations. In the drawings, the thicknesses of layers and regions are exaggerated for clarity. Accordingly, variations from the shapes of the illustrations as a result, for example, of manufacturing techniques and/or tolerances, are to be expected. Thus, exemplary embodiments should not be construed as limited to the shapes of regions illustrated herein but are to include deviations in shapes that result, for example, from manufacturing. For example, an etching region illustrated as a rectangle will, typically, have rounded or curved features. Thus, the regions illustrated in the figures are schematic in nature and their shapes are not intended to illustrate the actual shape of a region of a device and are not intended to limit the scope of exemplary embodiments.

Hereinafter, exemplary embodiments of the invention will be described in detail with reference to the accompanying drawings.

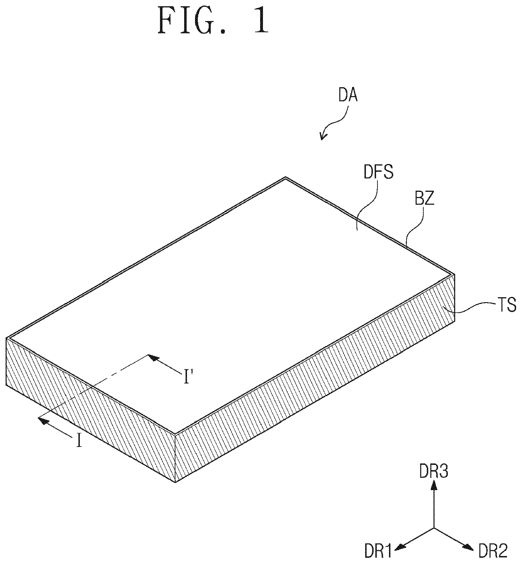

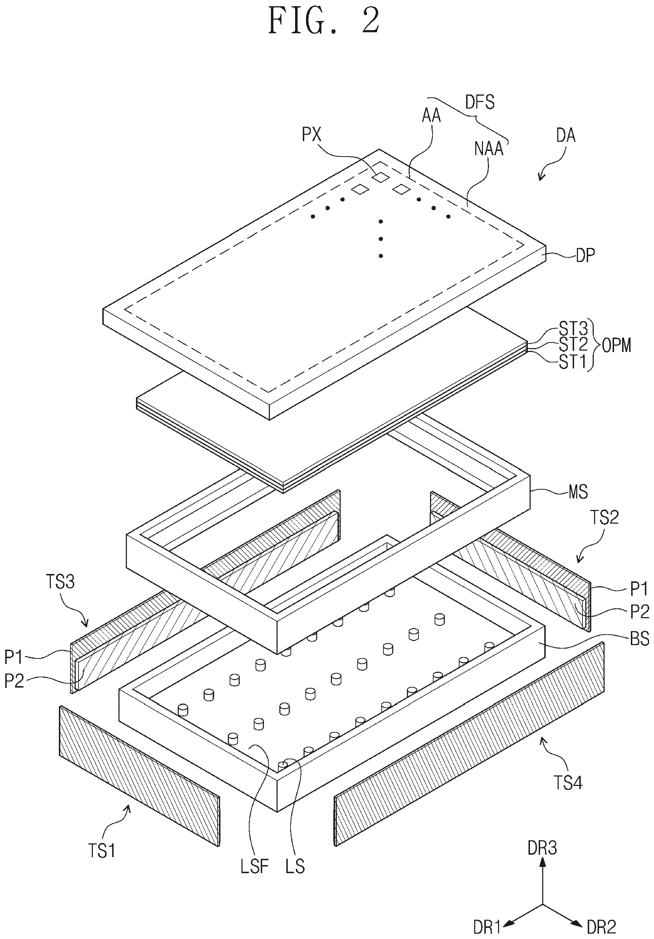

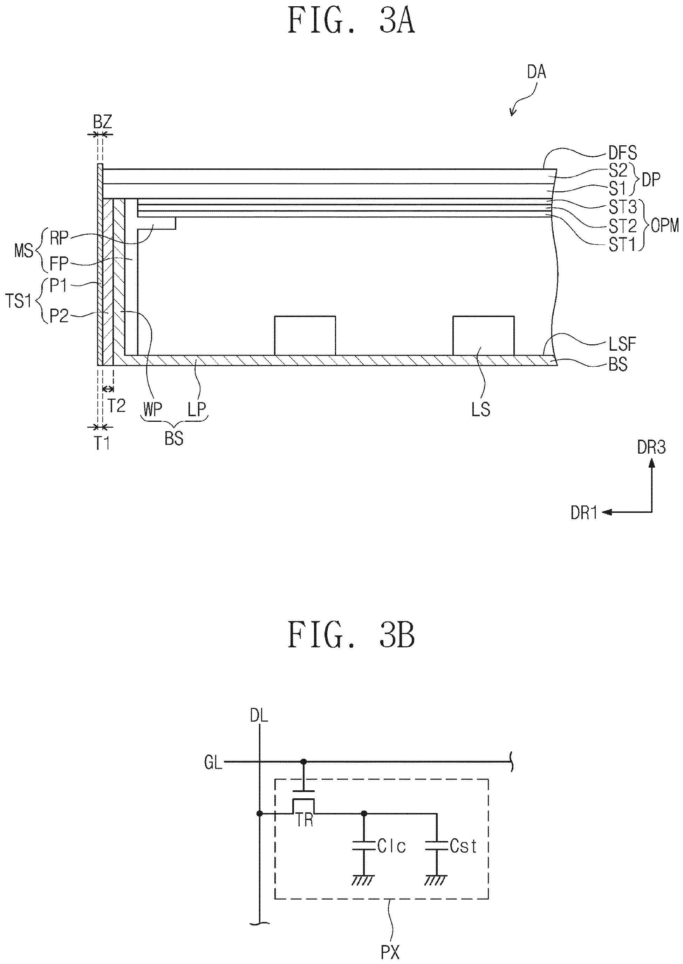

FIG. 1 is a combined perspective view illustrating a display apparatus according to an embodiment of the invention. FIG. 2 is an exploded perspective view illustrating the display apparatus of FIG. 1. FIG. 3A is a cross-sectional view taken along line I-I' of FIG. 1, and FIG. 3B is an equivalent circuit diagram of a portion of a display panel illustrated in FIG. 2. Hereinafter, an embodiment of the invention will be described with reference to FIGS. 1, 2, 3A and 3B.

As illustrated in FIG. 1, an embodiment of a display apparatus DA may include a display surface DFS, which is defined by first and second directions DR1 and DR2, and a bezel BZ. The display surface DFS may display an image in a third direction (e.g., an upward direction) DR3. The bezel BZ may surround an edge of the display surface DFS. The bezel BZ may be visible to a user when the user views the display surface DFS.

A side protective member TS may define an outer side of the display apparatus DA. In an embodiment, the bezel BZ may be defined by a surface of the side protective member TS facing the third direction DR3. In such an embodiment, a size or a width of the bezel BZ may be determined based on a thickness of the side protective member TS when viewed in a direction toward the display surface DFS (e.g., a direction opposite to the third direction DR3).

In an embodiment, as illustrated in FIG. 2, the display apparatus DA may include a display panel DP, an optical member OPM, an intermediate protective member MS, a bottom protective member BS, a plurality of side protective members TS1, TS2, TS3 and TS4, and light sources LS. The side protective members TS1, TS2, TS3 and TS4 may be assembled with each other to constitute the side protective member TS illustrated in FIG. 1.

The display panel DP may define the display surface DFS described above. The display surface DFS may correspond to a top surface of the display panel DP. In an embodiment, the display surface DFS may include an active area AA and a peripheral area NAA. The active area AA may display an image by an electrical signal. A plurality of pixels PX may be arranged in the active area AA.

In one embodiment, for example, the display panel DP may be an organic light emitting display panel, a liquid crystal display panel, a plasma display panel, an electrophoretic display panel, or an electrowetting display panel. Hereinafter, for convenience of description, embodiments where the display panel DP is the liquid crystal display panel will be described in detail.

In an embodiment, the display panel DP may include a first substrate S1 and a second substrate S2 which are sequentially stacked when viewed in a cross-sectional view. Each of the first and second substrates S1 and S2 may include a glass substrate, a plastic substrate or a metal substrate, or may have a stack structure including one or more inorganic layers and/or one or more organic layers. The first substrate S1 and the second substrate S2 may include a same material as each other or different materials from each other. In one embodiment, for example, each of the first and second substrates S1 and S2 may be a glass substrate or a plastic substrate. Alternatively, the first substrate S1 may be a glass substrate or a plastic substrate and the second substrate S2 may be a stack structure including inorganic layers or a stack structure including an inorganic layer and an organic layer, or vice versa.

The pixels PX may be disposed between the first substrate S1 and the second substrate S2. An equivalent circuit diagram of an exemplary embodiment of a pixel PX is illustrated in FIG. 3B for the purpose of ease and convenience in description and illustration.

Referring to FIG. 3B, the pixel PX may be connected to a gate line GL and a data line DL, and may include a thin film transistor TR, a liquid crystal capacitor Clc and a storage capacitor Cst. The thin film transistor TR may be turned-on by a gate signal provided through the gate line GL and may provide a data voltage provided through the data line DL to the liquid crystal capacitor Clc. The liquid crystal capacitor Clc may control alignment of liquid crystal molecules of a liquid crystal layer (not shown) in response to the data voltage, thereby controlling the amount of light passing through the liquid crystal layer. The storage capacitor Cst may assist the liquid crystal capacitor Clc to stably maintain the alignment of the liquid crystal molecules for a certain time. However, embodiments of the invention are not limited thereto. In such embodiments, the pixel PX may be variously designed or modified.

Referring back to FIGS. 1 to 3A, the peripheral area NAA may be adjacent to the active area AA. The peripheral area NAA may surround the active area AA when viewed in a plan view in the third direction DR3 (a direction normal to the display surface DFS or a thickness direction of the display panel DP). Signal lines, pads provided with external electrical signals, and/or a driving circuit may be disposed in the peripheral area NAA. However, embodiments of the invention are not limited thereto. In alternative embodiments, the peripheral area NAA may be adjacent to a single side of the active area AA in the display surface DFS or may be omitted.

The optical member OPM may be disposed under the display panel DP. The optical member OPM may be disposed between the display panel DP and the light sources LS, which will be described later in detail. The optical member OPM may include a plurality of optical sheets ST1, ST2 and ST3. In FIG. 2, an embodiment where the optical sheets includes first to third optical sheets ST1, ST2 and ST3 is illustrated for the purpose of ease and convenience in description.

Each of the first to third optical sheets ST1, ST2 and ST3 may include a diffusion sheet, a light concentrating sheet, a scattering sheet, a quantum dot sheet, or a light guide sheet. In an embodiment, at least two of the first to third optical sheets ST1, ST2 and ST3 may include a same sheet as each other. In an alternative embodiment, at least one of the first to third optical sheets ST1, ST2 and ST3 may be omitted. In another alternative embodiment, the optical member OPM may further include an additional sheet in addition to the first to third optical sheets ST1, ST2 and ST3. The optical member OPM may include various components, and the invention are not limited to a specific embodiment.

The intermediate protective member MS may be disposed under the display panel DP to support the display panel DP and the optical member OPM. In an embodiment, as shown in FIG. 3A, the intermediate protective member MS may include a flat portion FP and a protrusion RP. The flat portion FP may be vertical to the first direction DR1 or the second direction DR2. The flat portion FP may have a frame shape extending along an edge of a bottom surface of the display panel DP when viewed from the plan view in the third direction DR3.

The protrusion RP may protrude from the flat portion FP in the first direction DR1 or the second direction DR2 to support the optical member OPM. The optical member OPM may be spaced apart from the light sources LS by a predetermined distance by the intermediate protective member MS.

The bottom protective member BS may be disposed under the intermediate protective member MS. In an embodiment, as shown in FIG. 3A, the bottom protective member BS may include a bottom portion LP and a sidewall portion WP. The bottom portion LP and the sidewall portion WP may define an inner space which is opened upward. The light sources LS, the intermediate protective member MS and the optical member OPM may be received in the inner space.

The bottom portion LP may be parallel to a plane defined by the first direction DR1 and the second direction DR2. The bottom portion LP may be parallel to the display panel DP. The bottom portion LP may include a top surface LSF facing the optical member OPM. The top surface LSF may be spaced apart from the optical member OPM and the display panel DP in the third direction DR3. The light sources LS may be disposed on the top surface LSF. In an embodiment, the light sources LS may overlap the display panel DP when viewed in a top plan view to provide light upward.

The sidewall portion WP may be bent upward from the bottom portion LP. In an embodiment, the sidewall portion WP may surround an edge of the intermediate protective member MS.

The side protective member TS may surround an edge of the display panel DP and an edge of the bottom protective member BS when viewed in a plan view. In an embodiment, the side protective member TS may have a shape which surrounds a side surface of the display panel DP and a side surface of the bottom protective member BS.

The side protective member TS may be divided into a plurality of portions. In one embodiment, for example, the side protective member TS may include the first to fourth side protective members TS1, TS2, TS3 and TS4. The first and second side protective members TS1 and TS2 may face each other in the first direction DR1 and may extend in the second direction DR2. The third and fourth side protective members TS3 and TS4 may extend in the first direction DR1 and may face each other in the second direction DR2. Each of the first to fourth side protective members TS1, TS2, TS3 and TS4 may cover the side surface of the display panel DP and the sidewall portion WP of the bottom protective member BS, which correspond thereto.

Each of the first to fourth side protective members TS1, TS2, TS3 and TS4 may include a first panel P1 and a second panel P2. The first panel P1 and the second panel P2 of the first side protective member TS1 are illustrated in FIG. 3A for the purpose of ease and convenience in description.

The first panel P1 may be disposed outside the second panel P2. The first panel P1 may define an outer side surface of the display apparatus DA.

The second panel P2 may be coupled to the first panel P1. The second panel P2 may be covered by the first panel P1 and thus may not be visible from an outside. The second panel P2 may be disposed between the first panel P1 and the bottom protective member BS when viewed in a cross-sectional view.

A length of the first panel P1 in the third direction DR3 may be different from a length of the second panel P2 in the third direction DR3. In an embodiment, the length of the first panel P1 in the third direction DR3 may be greater than the length of the second panel P2 in the third direction DR3. In such an embodiment, the first panel P1 may protrude from the second panel P2 in the third direction DR3.

The first panel P1 may cover at least the display panel DP and the bottom protective member BS. Thus, the length of the first panel P1 in the third direction DR3 may be equal to or greater than a sum of a thickness of the display panel DP and a height of the sidewall portion WP of the bottom protective member BS.

The second panel P2 may cover at least the bottom protective member BS. The second panel P2 may not cover the side surface of the display panel DP. Thus, the second panel P2 may be spaced apart from the side surface of the display panel DP. A side surface of the display panel DP may be covered by the first panel P1 and may be exposed from the second panel P2.

The first panel P1 and the second panel P2 may have different thicknesses from each other. A first thickness T1 of the first panel P1 may be less than a second thickness T2 of the second panel P2.

Since the first panel P1 has the shape surrounding the edge of the display surface DFS, the first thickness T1 of the first panel P1 may be visible as the bezel BZ of the display apparatus DA to a user. A size of the bezel BZ visible to a user may decrease as the first thickness T1 decreases. In one embodiment, for example, the first thickness T1 may be about 0.1 millimeter (mm) or less. According to an embodiment of the invention, the first panel P1 may be designed to have the first thickness T1 which is relatively small, and thus the display apparatus DA with the narrow bezel may be provided.

The second panel P2 may not be exposed around the display surface DFS, and thus the second panel P2 may not constitute the bezel of the display apparatus DA. However, the second panel P2 may be coupled to the first panel P1 to compensate hardness or rigidity of the first panel P1. The second panel P2 surround the bottom protective member BS that receives components to protect, and may protect the bottom protective member BS, and the light sources LS, the intermediate protective member MS and the optical member OPM, which are received in the bottom protective member BS. In an embodiment, the second panel P2 may support a lower surface of the display panel DP.

As the second thickness T2 increases, the second panel P2 may easily protect inner components of the display apparatus DA. In one embodiment, for example, the second thickness T2 may be about 0.2 mm or more. According to an embodiment of the invention, the second panel P2 may be designed to have the second thickness T2 which is relatively great, and thus reliability of the display apparatus DA with respect to an external impact may be improved.

In an embodiment, the first panel P1 and the second panel P2 may include different materials from each other. In one embodiment, for example, the first panel P1 may include or be formed of a material having a higher workability than that of the second panel P2, and the second panel P2 may include or be formed of a material having a higher rigidity than that of the first panel P1. In one embodiment, for example, the first panel P1 may include or be formed of a resin including polyethylene terephthalate ("PET") or polycarbonate ("PC"), and the second panel P2 may include or be formed of a metal (e.g., aluminum (Al)) or an alloy (e.g., stainless steel).

In such an embodiment, where the first panel P1 includes or is formed of the material having the high workability, the first panel P1 having the first thickness T1, which is relatively small, may be effectively formed. In such an embodiment, since the second panel P2 includes or is formed of the material having the high rigidity, the reliability of the display apparatus DA may be improved. In such an embodiment, handling of the first panel P1 may be improved in manufacturing processes, and thus it may be easy to carry or assemble the side protective member including the first panel P1.

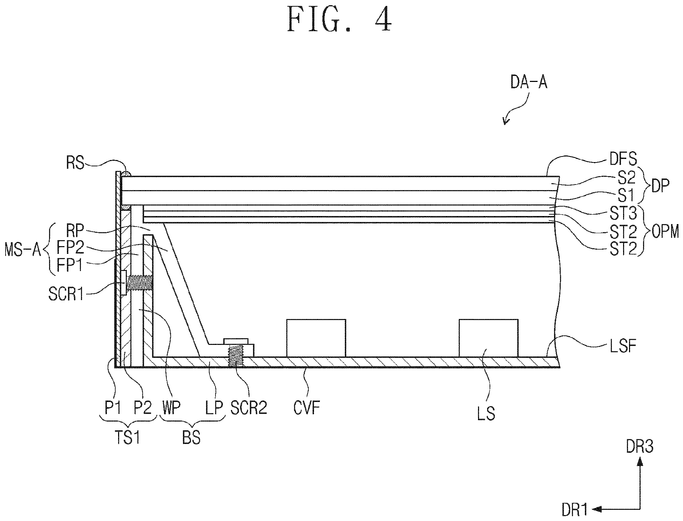

FIG. 4 is a cross-sectional view illustrating a display apparatus according to an alternative embodiment of the invention. An intermediate protective member MS-A of an embodiment of a display apparatus DA-A shown in FIG. 4 may be different from the intermediate protective member MS of an embodiment of the display apparatus DA shown in FIG. 3A. In such an embodiment, the display apparatus DA-A may further include a coupling member RS and a plurality of additional coupling members SCR1 and SCR2. Other components of the display apparatus DA-A of FIG. 4 may be substantially the same as corresponding components of the display apparatus DA of FIG. 3A. Hereinafter, the same components as described with reference to FIGS. 1 to 3B will be indicated by the same reference characters, and any repetitive detailed descriptions thereof will be omitted for the purpose of ease and convenience in description.

In an embodiment, as illustrated in FIG. 4, the intermediate protective member MS-A may include a first flat portion FP1, a second flat portion FP2, and a protrusion RP. The protrusion RP may correspond to the protrusion RP illustrated in FIG. 3A.

The first flat portion FP1 may surround the sidewall portion WP of the bottom protective member BS. The first flat portion FP1 may be parallel to the sidewall portion WP. A shape of the first flat portion FP1 may substantially correspond to the shape of the flat portion FP illustrated in FIG. 3A.

However, in such embodiment, the first flat portion FP1 may be disposed outside the bottom protective member BS. In such an embodiment, as shown in FIG. 4, the first flat portion FP1 may be disposed between the second panel P2 of the side protective member TS and the sidewall portion WP of the bottom protective member BS.

Each of the additional coupling members SCR1 and SCR2 may include a screw member. The second panel P2, the first flat portion FP1 and the sidewall portion WP may be coupled and fixed to each other by a first additional coupling member SCR1 of the additional coupling members SCR1 and SCR2. Thus, through-holes, through which the first additional coupling member SCR1 is disposed or disposed or inserted, may be defined in the second panel P2, the first flat portion FP, and the sidewall portion WP.

In an embodiment, the first additional coupling member SCR1 may be covered by the first panel P1. Thus, the first additional coupling member SCR1 may not be visible from an outside.

The second flat portion FP2 may extend from the protrusion RP to the bottom portion LP of the bottom protective member BS and may be spaced apart from the first flat portion FP1. The second flat portion FP2 may extend in an oblique direction to the bottom portion LP of the bottom protective member BS when viewed in a cross-sectional view. The sidewall portion WP may be disposed between the first flat portion FP1 and the second flat portion FP2.

In an embodiment, a portion of the second flat portion FP2 may be bent to be disposed on the bottom portion LP. The portion of the second flat portion FP2 and the bottom portion LP may be coupled and fixed to each other by a second additional coupling member SCR2 of the additional coupling members SCR1 and SCR2. Thus, through-holes, through which the second additional coupling member SCR2 is disposed or inserted, may be defined in the portion of the second flat portion FP2 and the bottom portion LP.

According to an embodiment of the invention, the display apparatus DA-A further includes the additional coupling members SCR1 and SCR2, such that coupling strength among the intermediate protective member MS-A, the bottom protective member BS and the side protective member TS may be improved.

In an embodiment, as shown in FIG. 4, the display apparatus DA-A may further include a cover member CVF and the coupling member RS. The cover member CVF may cover both at least a portion of the side protective member TS and at least a portion of the bottom protective member BS. In such an embodiment, the cover member CVF may cover a portion of the first panel P1, a portion of the bottom portion LP, and a connecting portion of the side protective member TS and the bottom protective member BS such that the side protective member TS is effectively prevented from being separated from the bottom protective member BS, and the aesthetics of the display apparatus DA-A may be improved.

In an embodiment, the coupling member RS may be disposed between the display panel DP and the first panel P1 to improve coupling strength between the display panel DP and the side protective member TS. In such an embodiment, the coupling member RS may prevent the display panel DP from moving in the first direction DR1 and/or the second direction DR2 and may prevent a collision between the display panel DP and the side protective member TS to improve the reliability of the display apparatus DA-A. In one embodiment, for example, the coupling member RS may include an adhesive resin or a double-sided tape. However, embodiments of the invention are not limited thereto. In alternative embodiments, the coupling member RS may include at least one of other various materials and components capable of coupling the display panel DP and the first panel P1 to each other. In other alternative embodiments, the coupling member RS may be omitted and the display panel DP may be in direct contact with the first panel P1.

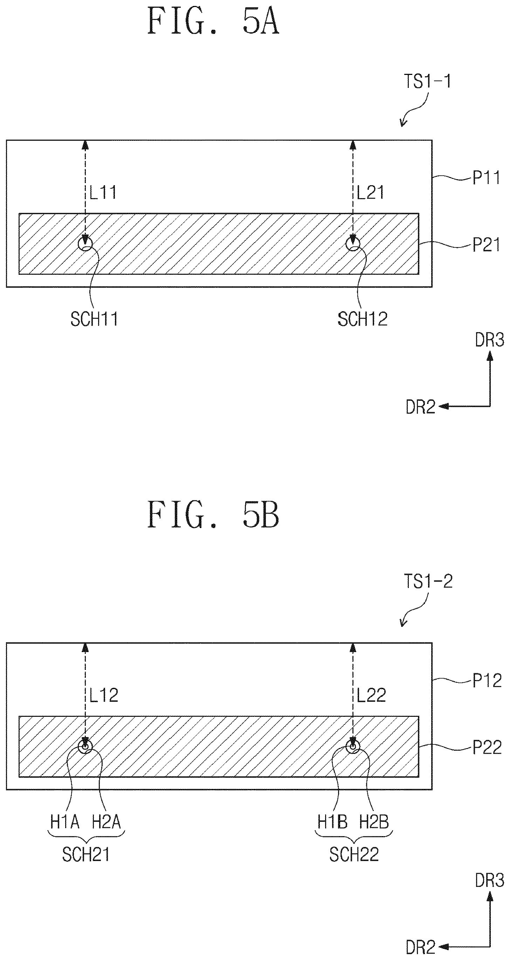

FIGS. 5A to 5C are side views illustrating side protective members according to some embodiments of the invention. Embodiments of the first side protective member TS1-1 TS1-2 and TS1-3 (hereinafter, referred to as side protective members) are illustrated in FIGS. 5A to 5C, respectively. Hereinafter, embodiments of the invention will be described with reference to FIGS. 5A to 5C. Hereinafter, the same components as described with reference to FIGS. 1 to 4 will be indicated by the same reference characters, and any repetitive detailed description thereof will be omitted for the purpose of ease and convenience in description.

In an embodiment, as illustrated in FIG. 5A, the side protective member TS1-1 may include at least one through-hole. In an embodiment, the side protective member TS1-1 may include a first through-hole SCH11 and a second through-hole SCH12 which are spaced apart from each other in the second direction DR2.

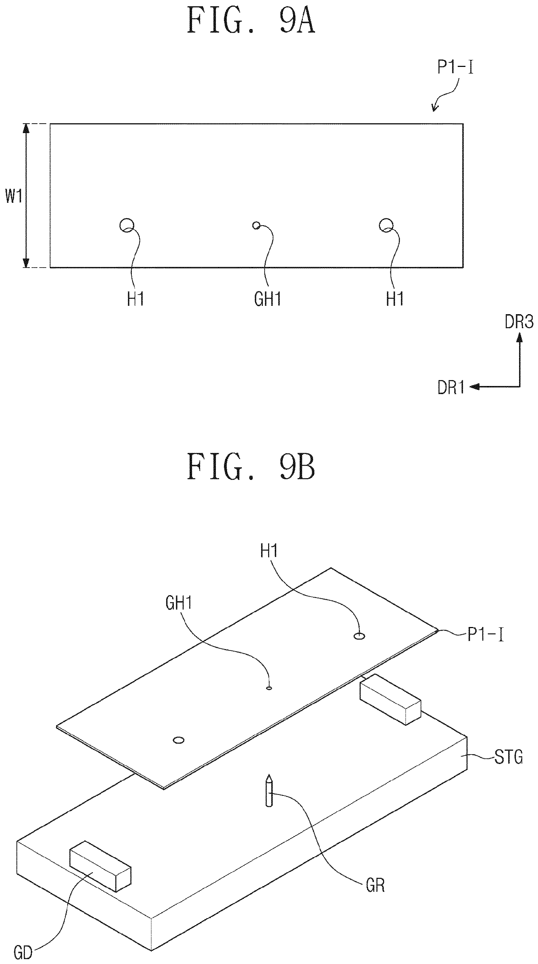

Each of the first and second through-holes SCH11 and SCH12 may be defined through both a first panel P11 and a second panel P21 which are coupled to each other. Thus, a hole defined in the first panel P11 and a hole defined in the second panel P21 may have a same shape as each other in a side view and may be aligned with each other to define each of the first and second through-holes SCH11 and SCH12. Each of the first and second through-holes SCH11 and SCH12 may be a hole through which the additional coupling member SCR1 (see FIG. 4) is disposed or inserted, or a hole through which a guide rod GR for alignment (see FIG. 9B) to be described later is disposed or inserted.

In such an embodiment, a first distance L11 measured from a center of the first through-hole SCH11 to a top edge (or side) of the first panel P11 in the third direction DR3 may be substantially equal to a second distance L21 measured from a center of the second through-hole SCH12 to the top edge of the first panel P11 in the third direction DR3. According to an embodiment of the invention, the first distance L11 may be substantially equal to the second distance L21, and thus the bezel BZ (see FIG. 1) is effectively prevented from being unevenly disposed in a cross-sectional view with respect to the display surface DFS (see FIG. 1).

In an alternative embodiment, as illustrated in FIG. 5B, each of first and second through-holes SCH21 and SCH22 of the side protective member TS1-2 may be defined by holes having different shapes from each other. In one embodiment, for example, the first through-hole SCH21 may be defined by a first hole H1A and a second hole H2A, and the second through-hole SCH22 may be defined by a third hole H1B and a fourth hole H2B. A size of the first hole H1A may be less than a size of the second hole H2A, and a size of the third hole H1B may be less than a size of the fourth hole H2B.

The first hole H1A and the second hole H2A may be defined in different panels. In one embodiment, for example, the first hole H1A may be defined in one of a first panel P12 and a second panel P22, and the second hole H2A may be defined in the other of the first panel P12 and the second panel P22. In such an embodiment, the third hole H1B may be defined in one of the first panel P12 and the second panel P22, and the fourth hole H2B may be defined in the other of the first panel P12 and the second panel P22.

In an embodiment, the first hole H1A and the second hole H2A may have different sizes from each other but may be concentric with each other. In such an embodiment, the third hole H1B and the fourth hole H2B may have the different sizes but may be concentric with each other. A first distance L12 from a center of the first through-hole SCH21 to a top edge of the first panel P12 may be substantially equal to a second distance L22 from a center of the second through-hole SCH22 to the top edge of the first panel P12. According to an embodiment of the invention, the first panel P12 and the second panel P22 may be easily aligned with each other through the holes having the different sizes, and a uniform bezel BZ may be formed.

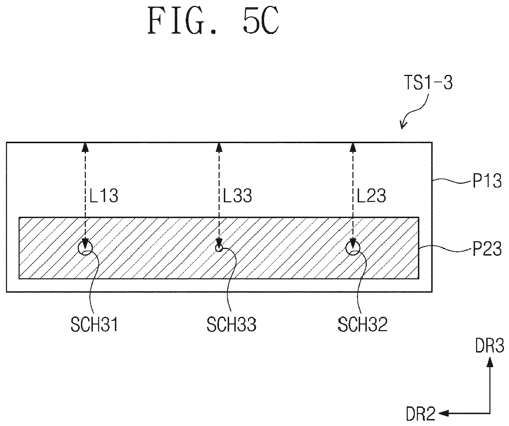

In another alternative embodiment, as illustrated in FIG. 5C, the side protective member TS1-3 may include first to third through-holes SCH31, SCH32 and SCH33. The first through-hole SCH31 and the second through-hole SCH32 may be spaced apart from each other in the second direction DR2 and may have a first distance L13 and a second distance L23 from a top edge of a first panel P13, respectively. The first distance L13 may be substantially equal to the second distance L23.

The third through-hole SCH33 may be disposed between the first through-hole SCH31 and the second through-hole SCH32. The third through-hole SCH33 may have a function different from that of the first through-hole SCH31 and the second through-hole SCH32. In one embodiment, for example, each of the first and second through-holes SCH31 and SCH32 may be a hole into which the additional coupling member SCR1 is coupled, and the third through-hole SCH33 may be a hole through which the guide rod GR (shown in FIG. 9B) is disposed or inserted. Thus, a size of the third through-hole SCH33 may be less than those of the first and second through-holes SCH31 and SCH32.

However, embodiments of the invention are not limited thereto. In other alternative embodiments, the third through-hole SCH33 may be a hole coupled to the additional coupling member SCR1, or the first to third through-holes SCH31, SCH32 and SCH33 may have a same function as each other. In some embodiments, the first to third through-holes SCH31, SCH32 and SCH33 may be variously modified or changed.

In an embodiment, a third distance L33 from a center of the third through-hole SCH33 to the top edge of the first panel P13 in the third direction DR3 may affect alignment and design of the first panel P13 and a second panel P23. In an embodiment, the first to third distances L13, L23 and L33 may be designed to be substantially equal to each other. Thus, a degree of alignment of the first and second panels P13 and P23 coupled to each other may be improved, and a uniform bezel may be formed.

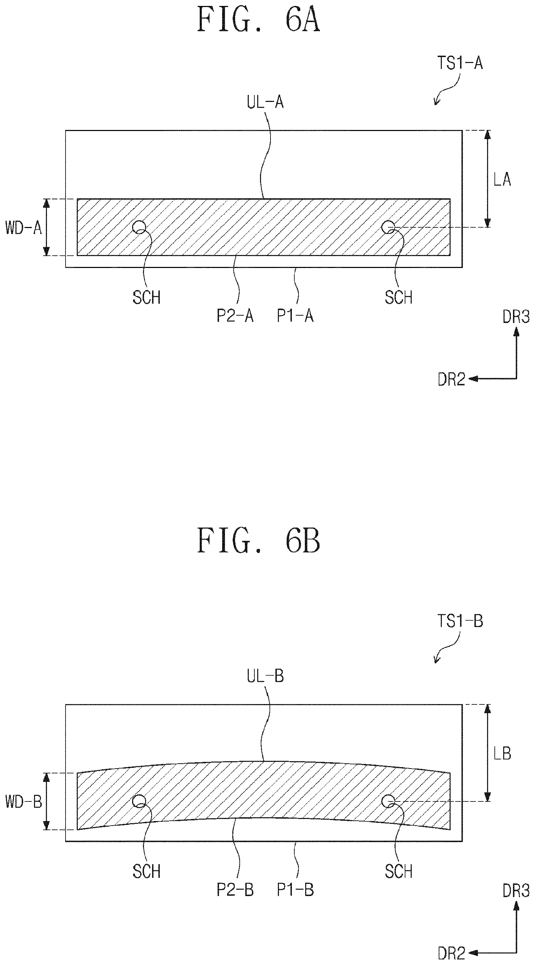

FIGS. 6A to 6C are side views illustrating side protective members according to some embodiments of the invention. Embodiments of the first side protective member TS1-A, TS1-B and TS1-C (hereinafter, referred to as side protective members) are illustrated in FIGS. 6A to 6C, respectively. Hereinafter, embodiments of the invention will be described with reference to FIGS. 6A to 6C. In addition, the same components as described with reference to FIGS. 1 to 5C will be indicated by the same reference characters, and any repetitive detailed descriptions thereof will be omitted for the purpose of ease and convenience in description.

In an embodiment, as illustrated in FIG. 6A, the side protective member TS1-A may include a plurality of through-holes SCH defined through a first panel P1-A and a second panel P2-A. Distances LA from centers of the through-holes SCH to a top edge of the first panel P1-A in the third direction DR3 may be substantially equal to each other.

In such an embodiment, as described above, a height WD-A of the second panel P2-A in the third direction DR3 may be less than a height of the first panel P1-A in the third direction DR3. The height WD-A of the second panel P2-A may be referred to as a width of the second panel P2-A. In an embodiment, a top edge UL-A of the second panel P2-A may extend in parallel to the second direction DR2. The height WD-A of the second panel P2-A may be constant along the second direction DR2.

In an alternative embodiment, as illustrated in FIG. 6B, the side protective member TS1-B may include a first panel P1-B and a second panel P2-B. The second panel P2-B may have a height WD-B measured in the third direction DR3. The height WD-B of the second panel P2-B may be referred to as a width of the second panel P2-B. The height WD-B of the second panel P2-B may be constant along the second direction DR2.

However, in such an embodiment, a top edge UL-B of the second panel P2-B may have a shape bent or curved along the second direction DR2. Thus, a distance between the top edge UL-B of the second panel P2-B and a top edge of the first panel P1-B may be changed along the second direction DR2. A bottom edge of the second panel P2-B may have a shape corresponding to the shape of the top edge UL-B of the second panel P2-B, such that the height WD-B of the second panel P2-B may be constant.

In an embodiment, distances LB from centers of through-holes SCH to the top edge of the first panel P1-B in the third direction DR3 may be substantially equal to each other. According to such an embodiment of the invention, even though the distance between the top edge UL-B of the second panel P2-B and the top edge of the first panel P1-B is changed along the second direction DR2, the distances LB from the centers of the through-holes SCH to the top edge of the first panel P1-B may be uniformly maintained.

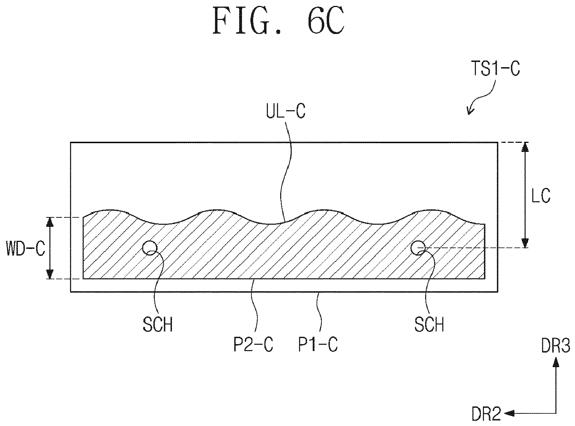

In another alternative embodiment, as illustrated in FIG. 6C, the side protective member TS1-C may include a second panel P2-C having a top edge UL-C which extends in the second direction DR2 while making a plurality of bends or curves. Thus, a distance between the top edge UL-C of the second panel P2-C and a top edge of a first panel P1-C may be changed along the second direction DR2. In such an embodiment, a height WD-C of the second panel P2-C in the third direction DR3 may be changed along the second direction DR2.

In such an embodiment, distances LC from centers of through-holes SCH to the top edge of the first panel P1-C in the third direction DR3 may be substantially equal to each other in the side protective member TS1-C. Thus, even though the second panel P2-C has the non-uniform height WD-C or has the top edge UL-C having a non-standard shape, the distances LC from the centers of the through-holes SCH to the top edge of the first panel P1-C may be uniformly maintained to minimize a tolerance.

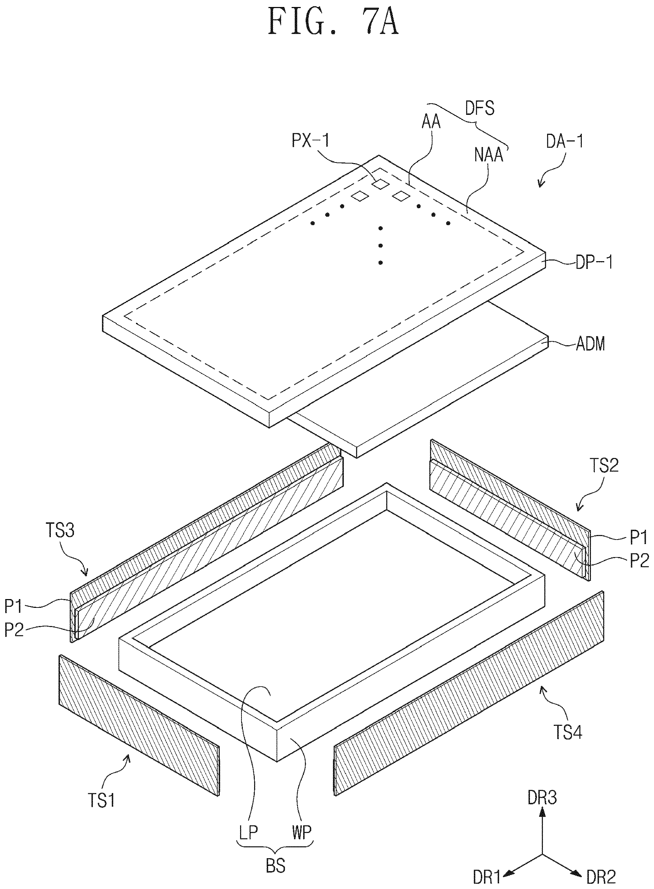

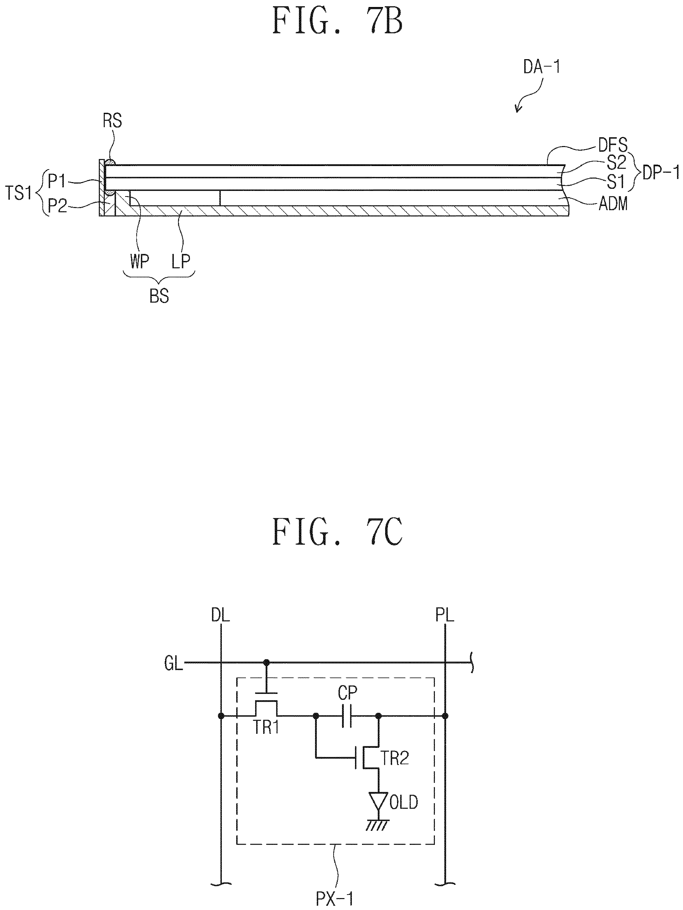

FIG. 7A is an exploded perspective view illustrating a display apparatus according to an alternative embodiment of the invention, and FIG. 7B is a combined cross-sectional view illustrating the display apparatus of FIG. 7A. FIG. 7C is an equivalent circuit diagram schematically illustrating a component of the display apparatus of FIG. 7A. Hereinafter, an embodiment of the invention will be described with reference to FIGS. 7A to 7C. In addition, the same components as described with reference to FIGS. 1 to 6C will be indicated by the same reference characters, and any repetitive detailed descriptions thereof will be omitted for the purpose of ease and convenience in description.

An embodiment of a display apparatus DA-1 may include a display panel DP-1, an auxiliary member ADM, a bottom protective member BS, and first to fourth side protective members TS1, TS2, TS3 and TS4. In such an embodiment, the display panel DP-1 may be a self-luminous display panel. In one embodiment, for example, the display panel DP-1 may include an organic light emitting display panel. Thus, a separate light source (see LS of FIG. 2) may be omitted in the display apparatus DA-1, unlike the display apparatus DA of FIG. 2.

The display panel DP-1 may include a first substrate S1, a second substrate S2, and pixels PX-1 disposed between the first substrate S1 and the second substrate S2. The first substrate S1 and the second substrate S2 may substantially correspond to the first substrate S1 and the second substrate S2 of FIG. 3A, respectively. An equivalent circuit diagram of an embodiment of a pixel PX-1 is illustrated in FIG. 7C for the purpose of ease and convenience in description.

Referring to FIG. 7C, the pixel PX-1 may be connected to a gate line GL, a data line DL, and a power line PL and may include a first thin film transistor TR1, a second thin film transistor TR2, a capacitor CP, and a light emitting element OLD. The pixel PX-1 may receive a gate signal from the gate line GL and may receive a data signal from the data line DL. The pixel PX-1 may receive a power voltage from the power line PL.

The first thin film transistor TR1 may output the data signal, applied to the data line DL, in response to the gate signal applied to the gate line GL. The capacitor CP may be charged with a voltage corresponding to the data signal received from the first thin film transistor TR1.

The second thin film transistor TR2 may be connected to the light emitting element OLD. The second thin film transistor TR2 may control a driving current, flowing through the light emitting element OLD, in response to the amount of charges stored in the capacitor CP. The light emitting element OLD may emit light during a turn-on period of the second thin film transistor TR2. However, the configuration of the pixel PX-1 is not limited thereto but may be variously modified in embodiments. The light emitting element OLD may include an organic light emitting element or a quantum dot light emitting element.

Referring again to FIGS. 7A and 7B, the auxiliary member ADM may be disposed between the display panel DP-1 and the bottom protective member BS. The auxiliary member ADM may be disposed on a bottom portion LP of the bottom protective member BS and may be received in the bottom protective member BS. The auxiliary member ADM may be a component for assisting the display panel DP-1 to drive. In one embodiment, for example, the auxiliary member ADM may include at least one of a driving circuit, a battery, or a sensor for sensing heat, light, and/or force.

In such an embodiment, the intermediate protective member MS of FIG. 2 may be omitted. Thus, the display panel DP-1 may be disposed on the auxiliary member ADM and may be supported by the bottom protective member BS. However, embodiments of the invention are not limited thereto. In an alternative embodiment, the display apparatus DA-1 may further include the intermediate protective member MS for supporting the display panel DP-1 and/or other component(s).

The first to fourth side protective members TS1, TS2, TS3 and TS4 may surround the display panel DP-1 and a sidewall portion WP of the bottom protective member BS. Each of the first to fourth side protective members TS1, TS2, TS3 and TS4 may include a first panel P1 and a second panel P2. The first panel P1 may surround a side surface of the display panel DP-1, and the second panel P2 may be spaced apart from the display panel DP-1 and may surround an outer side of the bottom protective member BS. The display panel DP-1 and the side protective members TS1 to TS4 may be physically coupled to each other by a coupling member RS.

According to an embodiment of the invention, the first to fourth side protective members TS1, TS2, TS3 and TS4 may easily cover the display panel DP-1 and the bottom protective member BS regardless of a kind of the display panel DP-1. As a result, the display apparatus DA-1 including the self-luminous display panel may also include the narrow bezel.

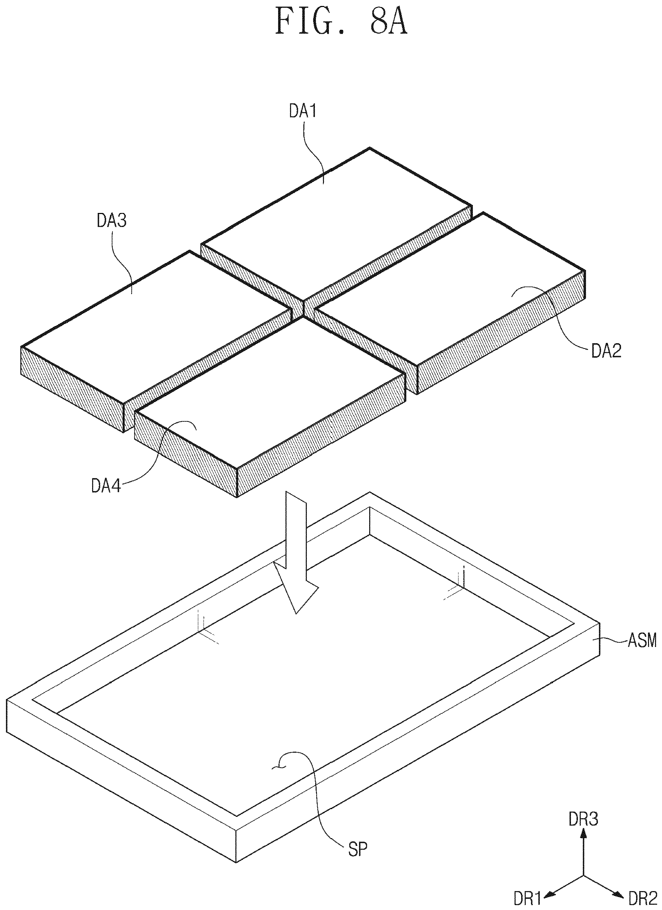

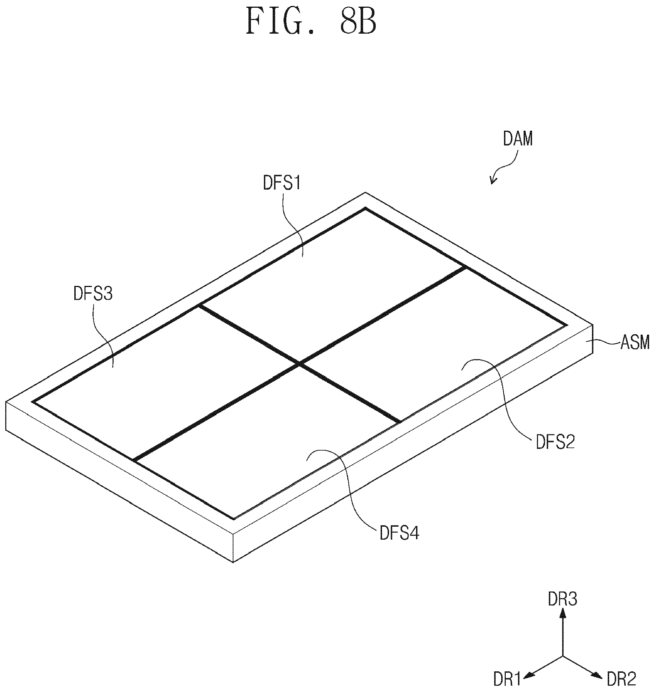

FIGS. 8A and 8B are perspective views illustrating an electronic apparatus according to an embodiment of the invention. FIG. 8A is an exploded perspective view of an electronic apparatus DAM, and FIG. 8B is a combined perspective view of the electronic apparatus DAM. Hereinafter, an embodiment of the invention will be described with reference to FIGS. 8A and 8B. In addition, the same components as described with reference to FIGS. 1 to 7C will be indicated by the same reference characters, and the any repetitive detailed descriptions thereof will be omitted for the purpose of ease and convenience in description.

An embodiment of the electronic apparatus DAM may include a plurality of display surfaces arranged adjacent to each other in a plan view. In such an embodiment, as shown in FIG. 8B, the electronic apparatus DAM may include first to fourth display surfaces DFS1, DFS2, DFS3 and DFS4, for example. The first display surface DFS1 and the second display surface DFS2 may be disposed adjacent to each other in the second direction DR2, the third display surface DFS3 may be disposed adjacent to the first display surface DFS1 in the first direction DR1, and the fourth display surface DFS4 may be disposed adjacent to the second display surface DFS2 in the first direction DR1.

Referring to FIG. 8A, the electronic apparatus DAM may include a plurality of display apparatuses. The electronic apparatus DAM may include first to fourth display apparatuses DA1, DA2, DA3 and DA4 and a receiving member ASM. The first to fourth display apparatuses DA1, DA2, DA3 and DA4 may provide the first to fourth display surfaces DFS1, DFS2, DFS3 and DFS4, respectively.

The receiving member ASM may provide a receiving space SP of which a top side is opened. The first to fourth display apparatuses DA1, DA2, DA3 and DA4 may be received into the receiving space SP along an arrow direction, and thus a single electronic apparatus DAM may be provided.

In an embodiment of the electronic apparatus DAM, as illustrated in FIG. 8B, each of the first to fourth display apparatuses DA1, DA2, DA3 and DA4 may include a narrow bezel defined by the side protective member. Thus, visibility of a boundary between the first to fourth display surfaces DFS1 to DFS4 of the first to fourth display apparatuses DA1 to DA4 may be reduced. According to an embodiment of the invention, the first to fourth display surfaces DFS1 to DFS4 may collectively display an image as a single display surface without sense of difference between the display surfaces, and thus the electronic apparatus DAM for displaying a large-sized image may be easily realized.

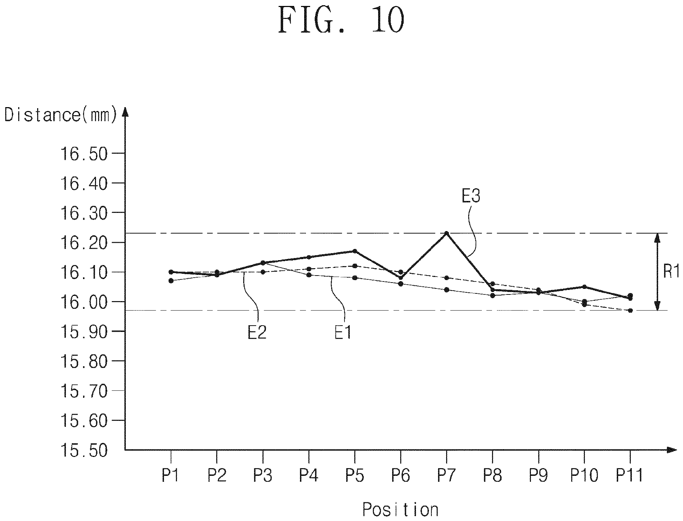

FIGS. 9A to 9F are views illustrating a method of manufacturing some components of a display apparatus, according to an embodiment of the invention. FIG. 10 is a graph showing straightness of a plurality of side protective members. FIGS. 9A to 9F illustrate a method of manufacturing a side protective member TS corresponding to the side protective member TS1-3 of FIG. 5C for the purpose of ease and convenience in description. In addition, shadings are omitted in FIGS. 9A to 9F. FIG. 10 shows straightness according to positions of side protective members E1, E2 and E3 according to some embodiments of the invention. The side protective member may include through-holes arranged in an extending direction thereof. The straightness may be measured by measuring a uniformity of distances (hereinafter, referred to as vertical lengths) which are measured from centers of the through-holes to a top edge of a first panel P1 in the third direction DR3. FIG. 10 shows vertical lengths measured from 11 positions corresponding to centers of 11 through-holes of each of the side protective members. Hereinafter, an embodiment of the invention will be described with reference to FIGS. 9A to 9F. In addition, the same components as described with reference to FIGS. 1 to 8B will be indicated by the same reference characters, and any repetitive detailed descriptions thereof will be omitted for the purpose of ease and convenience in description.

As illustrated in FIG. 9A, an initial first panel P1-I may be provided. The initial first panel P1-I may have a first height W1 defined in the third direction DR3. A plurality of through-holes may be formed in the initial first panel P1-I. The through-holes formed in the initial first panel P1-I may include a plurality of first holes H1 spaced apart from each other in the first direction DR1, and a first guide hole GH1 disposed between the first holes H1. In one embodiment, for example, the first holes H1 and the first guide hole GH1 may be formed by a physical method (e.g., a punching method) or a chemical method (e.g., an etching method).

In an embodiment, a size of the first guide hole GH1 may be less than sizes of the first holes H1. However, embodiments of the invention are not limited thereto. In alternative embodiments, the sizes of the first guide hole GH1 and the first holes H1 may be variously modified or changed depending on a manufacturing process environment.

Thereafter, as illustrated in FIG. 9B, the initial first panel P1-I may be disposed on a stage STG. The stage STG may provide a guide part GD and a guide rod GR. The guide part GD may be provided in plural, and the plurality of guide parts GD may be spaced apart from each other. The initial first panel P1-I may be disposed in a space between the guide parts GD.

The guide rod GR may be disposed in the space between the guide parts GD. The guide rod GR may have a rod shape protruding in a thickness direction of the initial first panel P1-I. The initial first panel P1-I may be disposed on the stage STG by aligning the first guide hole GH1 of the initial first panel P1-I with the guide rod GR.

When the initial first panel P1-I is disposed between the guide parts GD and the guide rod GR is inserted through the first guide hole GH1 of the initial first panel P1-I, it may be recognized that the initial first panel P1-I is stably disposed at a reference position.

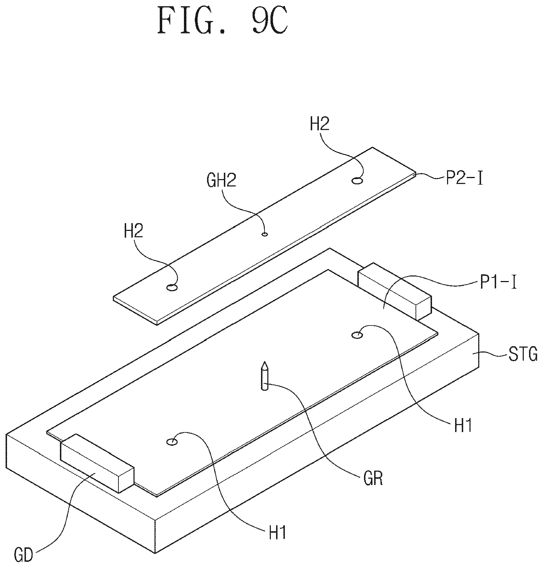

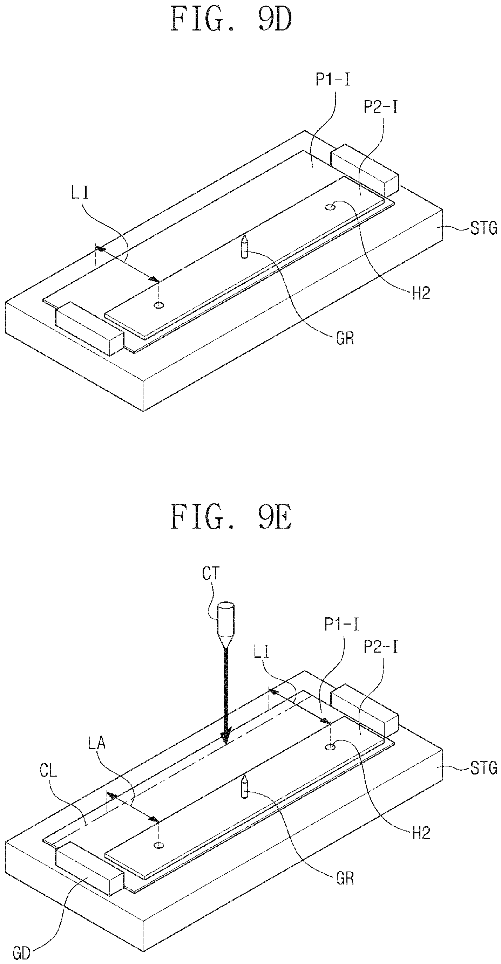

In such an embodiment, as illustrated in FIGS. 9C and 9D, an initial second panel P2-I may be coupled to the initial first panel P1-I. Referring to FIG. 9C, the initial second panel P2-I may be provided on the stage STG on which the initial first panel P1-I is aligned. The initial second panel P2-I may include a plurality of second holes H2 spaced apart from each other and a second guide hole GH2 disposed between the second holes H2.

Referring to FIG. 9D, the initial second panel P2-I may be disposed at a reference position of the stage STG by aligning the second holes H2 with the first holes H1 and aligning the second guide hole GH2 with the first guide hole GH1 and the guide rod GR. Thus, the entire portion of the initial second panel P2-I may be located on the initial first panel P1-I, and the guide rod GR may be disposed through the second guide hole GH2. At this time, centers of the second holes H2 may be spaced apart from a top edge of the initial first panel P1-I by a first distance LI.

In such an embodiment, even though not shown in the drawings, an adhesive member (not shown) may be disposed between the initial second panel P2-I and the initial first panel P1-I to physically couple the initial second panel P2-I to the initial first panel P1-I.

However, embodiments of the invention are not limited thereto. In an alternative embodiment, the initial first panel P1-I and the initial second panel P2-I may be aligned with each other by using the guide holes GH1 and GH2, and then, through-holes corresponding to the first holes H1 and the second holes H2 may be formed at one time in the initial first and second panels P1-I and P2-I coupled to each other. In this case, the first holes H1 and the second holes H2 may have a same size as each other with high alignment degree.

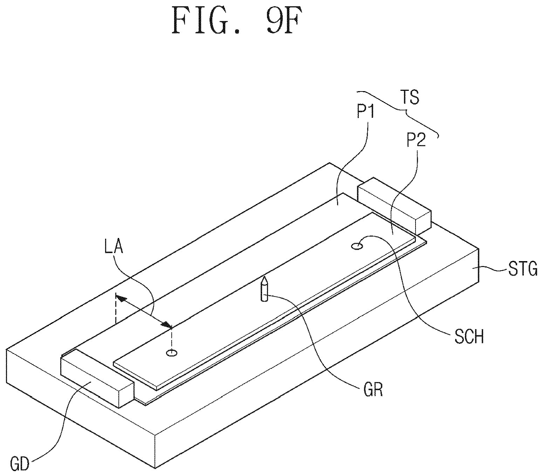

Thereafter, as illustrated in FIGS. 9E and 9F, a portion of the initial first panel P1-I may be removed to form a side protective member TS including a first panel P1 and a second panel P2. At this time, the second panel P2 may be substantially the same as the initial second panel P2-I.

Referring to FIG. 9E, the initial first panel P1-I may be cut along a cutting line CL defined at the initial first panel P1-I to remove the portion of the initial first panel P1-I. The cutting line CL may be defined at a position which is spaced apart from the center of each of the second holes H2 by a second distance LA. The second distance LA may be less than the first distance LI. In one embodiment, for example, a difference between the first distance LI and the second distance LA may be about 10 mm or less.

The initial first panel P1-I may be cut by a cutting module CT. The cutting module CT may cut the initial first panel P1-I along the cutting line CL to form the first panel P1.

The cutting module CT may include a plotter or a laser generator. The cutting module CT may be selected depending on a material of the initial first panel P1-I. In one embodiment, for example, where the initial first panel P1-I includes a resin, the cutting module CT may include a knife or the plotter. Thus, the cutting module CT may stably cut the initial first panel P1-I without heat deformation of the initial first panel P1-I.

In one alternative embodiment, for example, where the initial first panel P1-I includes a metal or an alloy, the cutting module CT may include the laser generator. Thus, a time of the process of cutting the initial first panel P1-I may be reduced. However, embodiments of the invention are not limited thereto. The process of cutting the initial first panel P1-I may be performed by at least one of other various cutting modules.

Referring to FIG. 9F, through-holes SCH may be defined by the first holes H1 and the second holes H2. Distances from centers of the through-holes SCH to the top edge of the first panel P1 may be designed as the second distance LA by the cutting process performed using the cutting module CT. According to an embodiment of the invention, the top edge of the first panel P1 may be uniformly formed along the cutting line CL, and the distances from the centers of the through-holes SCH to the top edge of the first panel P1 may also be uniformly maintained along the cutting line CL. Thus, workability of the side protective member TS may be improved and a tolerance range of the side protective member TS may be reduced.

Such features will be described with reference to FIG. 10. The following table 1 corresponds to FIG. 10.

**[Table 1]**

| Position | P1 | P2 | P3 | P4 | P5 | P6 | P7 | P8 | P9 | P10 | P11 |
|---|---|---|---|---|---|---|---|---|---|---|---|
| First embodiment (E1) | 16.07 | 16.09 | 16.13 | 16.09 | 16.08 | 16.06 | 16.04 | 16.02 | 16.03 | 16.00 | 16.02 |
| Second embodiment (E2) | 16.10 | 16.10 | 16.10 | 16.11 | 16.12 | 16.10 | 16.08 | 16.06 | 16.04 | 15.99 | 15.97 |
| Third embodiment (E3) | 16.10 | 16.03 | 16.13 | 16.15 | 16.17 | 16.08 | 16.18 | 16.04 | 16.03 | 16.05 | 16.01 |
| Average | 16.09 | 16.09 | 16.12 | 16.12 | 16.12 | 16.08 | 16.10 | 16.04 | 16.03 | 16.02 | 16.00 |

Referring to the table 1 and FIG. 10, in the first embodiment E1, the second embodiment E2 and the third embodiment E3, distances from the centers of the through-holes to the top edge of the first panel P1 are 16.10 mm ± 0.15 mm. In other words, a tolerance range R1 is ± 0.15 mm. That is, according to an embodiment of the invention, the second distances LA from the positions P1 to P11 of the centers of the through-holes to the top edge of the first panel P1 may be designed to be 16.10 mm ± 0.15 mm, and thus the first panel P1 may maintain the distance of about 16.10 mm. As a result, the side protective member TS having the improved straightness may be easily formed.

As discussed, embodiments can provide a display apparatus comprising: a display panel including a display surface on which an image is displayed in an upward direction; a bottom protective member comprising: a bottom portion parallel to the display panel; and a sidewall portion extending from the bottom portion in the upward direction; and a side protective member surrounding the sidewall portion and the display panel, wherein the side protective member comprises: a first panel having a first thickness and having a first portion arranged adjacent to the display panel, wherein the first panel exposes the display surface; and a second panel disposed between a second portion of the first panel and the sidewall portion, coupled to the second portion of the first panel, and having a second thickness greater than the first thickness.

The first portion of the first panel may be located in an upper region of the first panel, when compared to the second portion of the first panel.

The first portion of the first panel may be adjacent to a side surface of the display panel.

The side protective member may include a plurality of side protective members covering side surfaces of the display panel, respectively.

The side protective member may surround side surfaces of the display panel.

Embodiments can provide a method of manufacturing a display apparatus, the method comprising: providing a display panel; forming a side protective member; and assembling the side protective member with the display panel to cover an edge of the display panel, wherein the forming the side protective member comprises: providing an initial first panel having a first width on a stage; providing an initial second panel having a second width less than the first width on the stage in a way such that the initial second panel is stacked on the initial first panel; and cutting the initial first panel along a cutting line to form a first panel, wherein the cutting line is defined to be spaced apart from the initial second panel.

According to embodiments of the invention, the workability of the side protective member TS may be improved and the tolerance range of the side protective member TS may be reduced. According to the embodiments of the invention, the side protective member TS may be used in the display apparatus, and thus the aesthetics and assembly of the display apparatus may be improved.

According to embodiments of the invention, the display apparatus may include the side protective member which has sufficient resistance to an external impact and realizes a narrow bezel, and thus the aesthetics and reliability of the display apparatus may be improved.

In embodiments of the invention, the manufacturing method may improve the workability of the side protective member and may reduce the tolerance range. Thus, the assembly of the display apparatus may be improved.

While the invention have been described with reference to example embodiments, it will be apparent to those skilled in the art that various changes and modifications may be made without departing from the scopes of the invention. Therefore, it should be understood that the above embodiments are not limiting, but illustrative. Thus, the scopes of the invention are to be determined by the broadest permissible interpretation of the following claims and their equivalents, and shall not be restricted or limited by the foregoing description.

## Claims

1. A display apparatus comprising:
a display panel including a display surface on which an image is displayed in an upward direction;
a bottom protective member comprising:
a bottom portion parallel to the display panel; and
a sidewall portion extending from the bottom portion in the upward direction; and
a side protective member surrounding the sidewall portion and the display panel,
wherein the side protective member comprises:
a first panel having a first thickness and having a first portion arranged adjacent to the display panel; and
a second panel disposed between a second portion of the first panel and the sidewall portion, coupled to the second portion of the first panel, and having a second thickness greater than the first thickness.

2. The display apparatus of claim 1, wherein the side protective member includes a plurality of side protective members covering side surfaces of the display panel, respectively.

3. The display apparatus of claim 2, wherein the side surfaces of the display panel overlap the first panel and are exposed by the second panel when viewed in a side view.

4. The display apparatus of any one of claims 1 to 3, wherein the first panel includes a resin;
optionally wherein the second panel includes a metal or an alloy.

5. The display apparatus of any one of claims 1 to 4, further comprising:
a screw member which couples the side protective member and the bottom protective member to each other,
wherein the screw member is disposed through a through-hole defined in the first panel and the second panel.

6. The display apparatus of claim 5, wherein
a first through-hole and a second through-hole, which are spaced apart from each other in an intersection direction intersecting the upward direction, are defined in the side protective member,
the first panel has a top edge adjacent to the display surface, and
a distance from a center of the first through-hole to the top edge of the first panel in the upward direction is substantially equal to a distance from a center of the second through-hole to the top edge of the first panel in the upward direction.

7. The display apparatus of claim 6, wherein a distance between the top edge of the first panel and a top edge of the second panel is constant along the intersection direction; or
wherein a distance between the top edge of the first panel and a top edge of the second panel varies along the intersection direction.

8. The display apparatus of any one of claims 5 to 7, further comprising:
an intermediate protective member disposed between the display panel and the bottom protective member and supporting the display panel,
wherein the intermediate protective member comprises:
a flat portion disposed between the sidewall portion and the side protective member, wherein the screw member is disposed through the flat portion; and
a protrusion protruding from the flat portion in a direction intersecting the upward direction;
optionally wherein the intermediate protective member further comprises: an oblique portion extending obliquely from the protrusion toward the bottom portion, the sidewall portion is disposed between the flat portion and the oblique portion and is coupled to the flat portion, and the bottom portion is coupled to the oblique portion.

9. The display apparatus of any one of claims 1 to 8, further comprising:
a cover member covering the side protective member and the bottom protective member,
wherein the cover member covers at least a portion of the first panel and at least a portion of the bottom portion.

10. The display apparatus of any one of claims 1 to 9, further comprising:
a light source disposed on the bottom portion; and
an optical member disposed between the light source and the display panel.

11. The display apparatus of any one of claims 1 to 10, wherein the display panel comprises an organic light emitting element.

12. The display apparatus of any one of claims 1 to 11, further comprising:
a coupling member disposed between the display panel and the side protective member to couple the display panel and the side protective member to each other,
wherein the coupling member includes a resin or a tape.

13. A method of manufacturing a display apparatus, the method comprising:
providing a display panel;
forming a side protective member; and
assembling the side protective member with the display panel to cover an edge of the display panel,
wherein the forming the side protective member comprises:
providing an initial first panel having a first width on a stage;
providing an initial second panel having a second width less than the first width on the stage in a way such that the initial second panel is stacked on the initial first panel; and
cutting the initial first panel along a cutting line to form a first panel,
wherein the cutting line is defined to be spaced apart from the initial second panel.

14. The method of claim 13, wherein
a plurality of first through-holes is formed in the initial first panel to be arranged and spaced apart from each other in an extending direction of the cutting line,
a plurality of second through-holes is formed in the initial second panel to be arranged and spaced apart from each other in the extending direction of the cutting line, and
the initial second panel is provided on the stage in a way such that the second through-holes are aligned with the first through-holes, respectively;
optionally wherein distances from centers of the second through-holes to the cutting line are substantially equal to each other.

15. The method of claim 13 or 14, wherein a thickness of the initial first panel is less than a thickness of the initial second panel; and/or
wherein the cutting the initial first panel comprises using a plotter or a laser generator.
